# EUROPEAN PATENT APPLICATION

(11) **EP 4 815 491 A1**
(43) Date of publication of application: **30.09.2026**
(21) Application number: 24902434.0
(22) Date of filing: 05.11.2024
(51) Int. Cl.: H04Q 1/02

(54) **CHASSIS, NETWORK DEVICE AND COMMUNICATIONS SYSTEM**

(30) Priority: 15.12.2023 CN 202323446314 U
(71) Applicant: Huawei Technologies Co., Ltd., Shenzhen, Guangdong 518129 (CN)
(72) Inventor: LI, Jiang, Shenzhen, Guangdong 518129 (CN); ZHAN, Ce, Shenzhen, Guangdong 518129 (CN); YE, Shude, Shenzhen, Guangdong 518129 (CN)
(74) Representative: Gill Jennings & Every LLP
(86) International application number: PCT/CN2024/129915
(87) International publication number: WO 2025/124010

(57) **Abstract**

Embodiments of this application provide a chassis, a network device, and a communication system, relating to the field of communication technologies, to prevent damage to a cable or the chassis caused by foreign objects falling and impacting the connection position between the cable and the chassis. The chassis includes a service structure and a heat dissipation assembly. The service structure includes a plurality of boards and a plurality of ports. The ports are provided on the boards, and the ports are configured to connect to cables. The heat dissipation assembly is stacked on the service structure, and the heat dissipation assembly protrudes from a side of the service structure on which the ports are located.

## Description

This application claims priority to Chinese Patent Application No. 202323446314.8, filed with the China National Intellectual Property Administration on December 15, 2023 and entitled "CHASSIS, NETWORK DEVICE, AND COMMUNICATION SYSTEM", which is incorporated herein by reference in its entirety.

### TECHNICAL FIELD

The present utility model relates to the field of communication technologies, and in particular, to a chassis, a network device, and a communication system.

### BACKGROUND

A chassis is mainly used in network devices such as optical access central office equipment, switches, data centers, and servers, and is configured to process and distribute data or signals.

The chassis is provided with connection ports for connection to optical fiber cables. However, during operation, the connection positions between the chassis and the cables are susceptible to damage if foreign objects fall and strike the connection between the cables and the chassis.

### SUMMARY

An objective of this application is to provide a chassis, a network device, and a communication system, to prevent damage to a cable or the chassis caused by foreign object falling and impacting the connection position between the cable and the chassis.

To achieve the foregoing objective, the following technical solutions are used in embodiments of this application.

According to one aspect of embodiments of this application, a chassis is provided. The chassis includes a service structure and a heat dissipation assembly. The service structure includes a plurality of boards and a plurality of ports. The ports are provided on the boards, and the ports are configured to connect to cables. The heat dissipation assembly is stacked on the service structure, and the heat dissipation assembly protrudes from a side of the service structure on which the ports are located.

It can be learned from the foregoing description that the service structure includes the plurality of boards and the ports provided on the boards, and the boards may be connected to external cables through the ports, to send and receive signals. The heat dissipation assembly is stacked on the service structure, and the heat dissipation assembly protrudes from the side of the service structure on which the ports are provided. When a foreign object falls from above the service structure, a portion of the heat dissipation assembly protruding from the service structure can shield the location at which the ports are provided. After the cable is connected to the port, the portion of the heat dissipation assembly protruding from the service structure can shield the connection position between the cable and the port. This prevents the cable or the port of the chassis at the connection position from being impacted by the falling foreign object, thereby achieving the purpose of preventing damage to the cable or the chassis caused by the foreign object falling and impacting the connection position between the cable and the chassis.

In some embodiments of this application, the foregoing service structure may have a first surface and a second surface that are opposite to each other. The ports are located on the first surface. A distance between the first surface and an end of the heat dissipation assembly away from the second surface is h, where 0 cm<h≤100 cm. For example, h may be 1 cm, 10 cm, 30 cm, 50 cm, 70 cm, 90 cm, 100 cm, or the like. After the cable is connected to the port, the cable is located on a side of the first surface away from the second surface. In this case, the cable protrudes from the first surface. When the distance h between the first surface and the end of the heat dissipation assembly away from the second surface is greater than 0 cm, the heat dissipation assembly protrudes from the side of the service structure on which the ports are provided. That is, a portion of the heat dissipation assembly protruding from the first surface can shield the connection position between the cable and the port. In addition, when h is large, the portion of the heat dissipation assembly protruding from the first surface may further shield a portion of the cable protruding from the first surface, thereby preventing the foreign object from falling and impacting the shielded portion of the cable. In addition, as the cable gradually extends away from the port, the cable gradually sags due to gravity. In this case, the cable does not continue to extend in a direction away from the first surface. That is, a size of the cable protruding from the first surface does not increase infinitely. When the distance h between the first surface and the end of the heat dissipation assembly away from the second surface is less than or equal to 100 cm, a size of the heat dissipation assembly is reduced while the portion of the cable protruding from the first surface is shielded, thereby reducing costs.

In some embodiments of this application, a heat dissipation gap is provided between two adjacent boards, and the heat dissipation assembly may include a heat dissipation frame body and at least one fan disposed in a heat dissipation cavity. The heat dissipation frame body protrudes from the side of the service structure on which the ports are provided. The heat dissipation frame body has a heat dissipation cavity, and the heat dissipation cavity is in communication with the heat dissipation gap. It can be learned from the foregoing description that the heat dissipation frame body of the heat dissipation assembly has the heat dissipation cavity, and the fan may be disposed in the heat dissipation cavity. The fan generates an airflow during operation, thereby allowing air between the heat dissipation cavity and the heat dissipation gap to move, thereby achieving heat dissipation. In addition, a side of the heat dissipation frame body away from the back surface protrudes from the service structure. When a generated foreign object falls during installation or removal of the fan, the portion of the heat dissipation frame body protruding from the side of the service structure on which the ports are provided shields the connection position between the cable and the port. This prevents the cable or the port of the chassis at the connection position from being impacted by the falling foreign object, thereby achieving the purpose of preventing damage to the cable or the chassis caused by the generated foreign object falling and impacting the connection position between the cable and the chassis during the installation or removal of the fan. In addition, the side of the heat dissipation frame body away from the back surface protrudes from the service structure. A size of the heat dissipation frame body is large. In this case, the heat dissipation cavity of the heat dissipation frame body can accommodate a large quantity of fans, so that a heat dissipation effect of the heat dissipation assembly can be improved.

In some embodiments of this application, the heat dissipation assembly further includes an air mixing frame body, disposed between the service structure and the heat dissipation frame body. The air mixing frame body has an air mixing cavity, and the heat dissipation cavity and the heat dissipation gap are both in communication with the air mixing cavity. When the fan is in operation, a generated airflow converges in the air mixing cavity, so that a uniform air flow is generated in the air mixing cavity. This causes one heat dissipation gap below the air mixing frame body to generate airflows with similar air volumes in different regions on a same horizontal plane, thereby achieving uniform heat dissipation across the different regions of the same heat dissipation gap on the same horizontal plane. Alternatively, when there are a plurality of heat dissipation gaps, airflows with similar air volumes can be generated in different heat dissipation gaps, thereby achieving uniform heat dissipation across the different heat dissipation gaps. In addition, when there are a plurality of fans and one of the fans is faulty, airflows generated by the other fans during operation can converge in the air mixing cavity, to ensure that the heat dissipation assembly can dissipate heat from the heat dissipation gap located below the faulty fan.

In some embodiments of this application, the chassis may further include a power board vertically disposed in the air mixing cavity, and the boards and the fan are both electrically connected to the power board. The power board may be electrically connected to an external power supply. After the external power supply transmits electric power to the power board, the power board converts an input power supply voltage into operating voltages of various levels required by the boards and the fan, and then distributes the operating voltages to the boards and fan, to ensure the energy required by the boards and fan for operation. In addition, the power board is a plate-shaped structure, and a thickness of the power board is far less than a width of an air mixing structure. That is, the power board occupies very small space in the air mixing cavity. Moreover, because the power board is vertically disposed in the air mixing cavity, in this case, the power board hardly obstructs the vertically directed airflow generated within the air mixing cavity, so that air resistance in the air mixing cavity can be reduced, and the heat dissipation effect of the heat dissipation assembly can be ensured.

In some embodiments of this application, the service structure has a first surface and a second surface that are opposite to each other, and the ports are located on the first surface. The chassis may further include a cover plate disposed at an end of the air mixing frame body away from the second surface. An end of the cover plate facing the service structure is connected to the service structure, and an end of the cover plate away from the service structure is connected to the air mixing frame body. The cover plate covers an end surface of the air mixing frame body away from the second surface. It can be learned from the foregoing description that the cover plate covers the end surface of the air mixing frame body away from the second surface, to shield the air mixing frame body and the power board, and prevent damage to the air mixing frame body or the power board caused by impact from an external foreign object, thereby protecting the air mixing frame body and the power board disposed in the air mixing cavity.

In some embodiments of this application, the air mixing frame body is detachably connected to the service structure. The chassis may further include a support member. The support member is connected to the service structure, and the end of the cover plate facing the service structure is rotatably connected to the support member. It can be learned from the foregoing description that the air mixing frame body is detachably connected to the service structure, so that when the air mixing frame body or the power board disposed in the air mixing cavity needs to be repaired or replaced, the air mixing frame body may be taken out, to facilitate the repair or replacement. In addition, the support member is connected to the service structure, and the end of the cover plate facing the service structure is rotatably connected to the support member. When the air mixing frame body is removed, the cover plate can be flipped downward, to facilitate taking out the air mixing frame body. In addition, after the cover plate is flipped downward, the cover plate may shield the port of the service structure, to prevent a foreign object generated during installation or removal of the air mixing frame body from falling and impacting the connection position between the external cable and the port, thereby achieving the purpose of preventing damage to the cable or the chassis caused by the foreign object falling and impacting the connection position between the cable and the chassis.

In some embodiments of this application, the chassis further includes a backplane assembly. The service structure and the heat dissipation assembly are both disposed on a same side of the backplane assembly, and the backplane assembly includes a backplane body, and a cable group, a first connector, and a second connector that are disposed on the backplane body. One end of the first connector is electrically connected to the cable group, and the other end of the first connector is electrically connected to the boards. One end of the second connector is electrically connected to the cable group, and the other end of the second connector is electrically connected to the heat dissipation assembly. The backplane body can support the service structure, and ensure structural stability of the chassis. The cable group and the board are both electrically connected to the first connector. When electric power is input to the cable group, the electric power is transmitted to the board through the first connector, to provide energy for the operation of the board. In addition, when there are a plurality of boards, signal transmission and exchange between different boards can also be performed through the cable group. In addition, the cable group and the heat dissipation assembly are both electrically connected to the second connector. When electric power is input to the cable group, the electric power is transmitted to the heat dissipation assembly through the second connector, to provide energy for the operation of the heat dissipation assembly.

In some embodiments of this application, the chassis may further include a power board, the backplane assembly further includes a third connector, one end of the third connector is electrically connected to the cable group, and the other end of the third connector is electrically connected to the power board. The power board is connected to the cable group through the third connector. When electric power is input to the power board, the electric power is transmitted to the cable group through the third connector, and finally delivered to the board and the heat dissipation assembly, to provide energy for the operation of the board and the heat dissipation assembly.

Another aspect of embodiments of this application provides a network device. The network device may include the foregoing chassis. In addition, the network device may further include a cable, and the cable is connected to a port of the chassis. The foregoing network device has the same technical effects as the chassis provided in the foregoing embodiment. Details are not described herein again.

According to still another aspect of embodiments of this application, a communication system is provided. The communication system may include the foregoing network device. In addition, the communication system may further include a first access device, and the first access device is connected to the network device. The foregoing communication system has the same technical effects as the chassis provided in the foregoing embodiment. Details are not described herein again.

### BRIEF DESCRIPTION OF DRAWINGS

FIG. 1 is a diagram of a structure of a communication system according to an embodiment of this application;
FIG. 2 is a diagram of a structure of another communication system according to an embodiment of this application;
FIG. 3 is a diagram of a structure of a chassis according to an embodiment of this application;
FIG. 4 is a side view of a chassis according to an embodiment of this application;
FIG. 5 is a sectional view of a chassis when a cover plate is closed according to an embodiment of this application;
FIG. 6 is a sectional view of a chassis when a cover plate is opened according to an embodiment of this application; and
FIG. 7 is a diagram of assembly of an air mixing frame body and a power board according to an embodiment of this application.

### Reference numerals:

01: communication system; 02: network device; 10: chassis; 11: service structure; 111: board; 112: port; 113: first surface; 114: second surface; 115: heat dissipation gap; 12: heat dissipation assembly; 121: heat dissipation frame body; 1211: heat dissipation cavity; 122: fan; 123: air mixing frame body; 1231: air mixing cavity; 13: power board; 14: cover plate; 15: support member; 16: backplane assembly; 161: backplane body; 162: cable group; 163: first connector; 164: second connector; 165: third connector; 20: cable; 30: distribution frame; 03: first access device; 04: second access device; 05: foreign object.

### DESCRIPTION OF EMBODIMENTS

The following describes technical solutions in embodiments of this application with reference to the accompanying drawings in embodiments of this application. It is clear that the described embodiments are merely a part rather than all of embodiments of this application.

In the following description, terms such as "first", "second", and "third" are merely intended for ease of description, and shall not be understood as an indication or implication of relative importance or implicit indication of a quantity of indicated technical features. Therefore, a feature limited by "first", "second", or "third" may explicitly or implicitly include one or more such features. In the descriptions of this application, unless otherwise stated, "a plurality of" means two or more than two.

In this application, unless otherwise expressly specified and limited, the term "connection" should be understood in a broad sense. For example, the "connection" may be an electrical connection or an optical fiber connection; or the "connection" may be a fixed mechanical connection, a detachable mechanical connection, or an integrated connection; or the "connection" may be a direct connection, or may be an indirect connection through an intermediate medium.

In embodiments of this application, the word like "example" is used to represent giving an example, an illustration, or a description. Any embodiment or design scheme described as an "example" in embodiments of this application should not be explained as being more preferred or having more advantages than another embodiment or design scheme. Exactly, use of the word "example" or the like is intended to present a relative concept in a specific manner.

In the accompanying drawings of embodiments of this application, an assembly is represented by a guide line with an arrow, a component is represented by only a guide line, and a hollow structure like an opening or a hole is represented by a guide line with a hollow circle at an end.

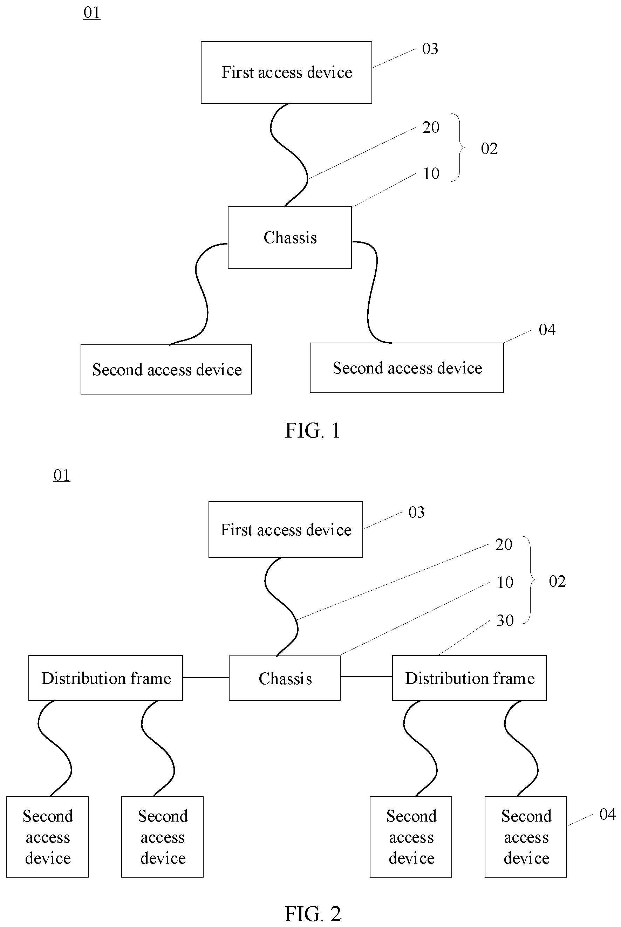

An embodiment of this application provides a communication system 01. As shown in FIG. 1, the communication system 01 may include a network device 02 and a first access device 03 connected to the network device 02. The first access device 03 may send a signal to the network device 02, and the network device 02 processes or stores the received signal. Alternatively, the network device 02 may send a signal to the first access device 03. Therefore, signal exchange between the network device 02 and the first access device 03 is achieved.

Still as shown in FIG. 1, the communication system 01 may further include a plurality of second access devices 04 connected to the network device 02. Similar to the first access device 03, signal exchange can also be performed between the second access device 04 and the network device 02. For example, the network device 02 may receive a signal sent by the first access device 03, and send the signal to different second access devices 04 after processing and distribution. Alternatively, the network device 02 may receive a signal sent by the second access device 04, and send the signal to the first access device 03.

In the foregoing embodiment, as shown in FIG. 1, an example in which the communication system 01 includes one network device 02, one first access device 03, and two second access devices 04 is used. In another embodiment of this application, the network device 02, the first access device 03, and the second access device 04 may be provided in other quantities.

In addition, still as shown in FIG. 1, the network device 02 includes a chassis 10 and a cable 20. One end of the cable 20 is connected to the chassis 10, and the other end of the cable 20 is configured to connect to the first access device 03 or the second access device 04. The first access device 03 or the second access device 04 is connected to the chassis 10 through a correspondingly connected cable 20, to transmit a signal.

The network device 02 may be optical access central office equipment, a switch, a data center, a server, or the like. For ease of description, the following uses an example in which the network device 02 is an optical access central office equipment for description.

As shown in FIG. 2, the network device 02 in the communication system 01 is optical access central office equipment. In this case, in some embodiments of this application, the first access device 03 may be a central office or a base station, and the second access device 04 may be an optical network terminal (Optical network terminal, ONT) or an optical network unit (Optical Network Unit, ONU). The cable 20 of the optical access central office equipment is an optical fiber cable. The optical access central office equipment further includes a distribution frame 30. The chassis 10 is connected to the first access device 03 through the optical fiber cable, and performs optical signal exchange. In addition, the chassis 10 is connected to the distribution frame 30 through the optical fiber cable, and performs optical signal exchange. Therefore, after the first access device 03 sends an optical signal to the chassis 10, the optical signal is distributed to different distribution frames 30 through the chassis 10, and then distributed to different second access devices 04 through the different distribution frames 30. Alternatively, the second access device 04 sends an optical signal to the chassis 10 through the distribution frame 30, and the chassis 10 processes the optical signal and sends a processed optical signal to the first access device 03, to complete transmission of the optical signal.

In the foregoing embodiment, as shown in FIG. 2, an example in which the communication system 01 includes one piece of optical access central office equipment, one first access device 03, and two second access devices 04, and the optical access central office equipment includes one chassis 10 and two distribution frames 30 is used. In another embodiment of this application, the optical access central office equipment, the first access device 03, and the second access device 04 may be provided in other quantities. The chassis 10 and the distribution frame 30 may also be provided in other quantities.

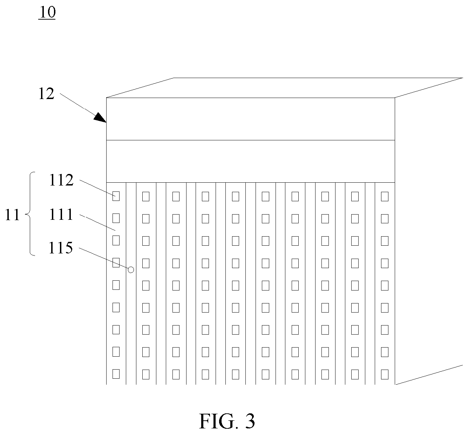

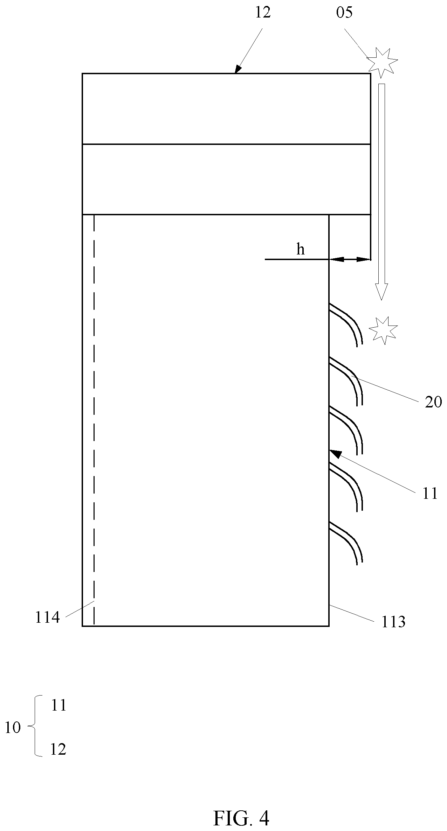

Based on this, in some embodiments of this application, as shown in FIG. 3, the chassis 10 may include a service structure 11 and a heat dissipation assembly 12. The service structure 11 includes a plurality of boards 111 and a plurality of ports 112. The ports 112 are provided on the boards 111, and the ports 112 are configured to connect to the cables 20 shown in FIG. 4. In this case, when the cable 20 is connected to the port 112 provided on the board 111, the board 111 can be connected to the cable 20 through the port 112, and can receive a signal transmitted by the first access device 03 (as shown in FIG. 2) or the second access device 04 (as shown in FIG. 2) to the cable 20. Alternatively, the board 111 may send a signal to the first access device 03 or the second access device 04 through the cable 20.

In addition, as shown in FIG. 4, the heat dissipation assembly 12 is stacked on the service structure 11, and the heat dissipation assembly 12 protrudes from a side of the service structure 11 on which the ports 112 (as shown in FIG. 3) are located. That is, there is a spacing between a first surface 113 and an end of the heat dissipation assembly 12 away from a second surface 114 shown in FIG. 4. After the cable 20 is connected to the port 112, a portion of the heat dissipation assembly 12 protruding from the service structure 11 can shield a connection position between the cable 20 and the port 112. When a foreign object 05 falls from above the service structure 11, the portion of the heat dissipation assembly 12 protruding from the service structure 11 can prevent the cable 20 or the port 112 of the chassis 10 at the connection position from being impacted by the falling foreign object 05, thereby achieving a purpose of preventing damage to the cable 20 or the chassis 10 caused by the foreign object 05 falling and impacting the connection position between the cable 20 and the chassis 10.

Further, still as shown in FIG. 4, in some embodiments of this application, the service structure 11 may have a first surface 113 and a second surface 114 that are opposite to each other. The ports 112 (as shown in FIG. 3) are located on the first surface 113. A distance between the first surface 113 and the end of the heat dissipation assembly 12 away from the second surface 114 is h, where 0 cm<h≤100 cm. When h is greater than 0 cm, the heat dissipation assembly 12 protrudes from the side of the service structure 11 on which the ports 112 are provided. That is, the portion of the heat dissipation assembly 12 protruding from the first surface 113 can shield the connection position between the cable 20 and the port 112. This prevents the cable 20 or the port 112 of the chassis 10 at the connection position from being damaged by impact from the falling foreign object 05.

In addition, after the cable 20 is connected to the port 112, the cable 20 is located on a side of the first surface 113 away from the second surface 114. In this case, the cable 20 protrudes from the first surface 113. To also protect the portion of the cable 20 protruding from the first surface 113, the distance h between the first surface 113 and the end of the heat dissipation assembly 12 away from the second surface 114 may be set large. In this way, the portion of the heat dissipation assembly 12 protruding from the first surface 113 may further shield the portion of the cable 20 protruding from the first surface 113, thereby further protecting the portion of the cable 20 close to the port 112, and preventing the portion of the cable 20 from being damaged by impact from the falling foreign object 05. In addition, as the cable 20 gradually extends away from the port 112, the cable 20 gradually sags due to gravity. In this case, the cable 20 does not continue to extend in a direction away from the first surface 113. That is, a size of the cable 20 protruding from the first surface 113 does not increase infinitely. Generally, the size of the cable 20 protruding from the first surface 113 is less than 100 cm. In this case, when the distance h between the first surface 113 and the end of the heat dissipation assembly 12 away from the second surface 114 is less than 100 cm, a size of the heat dissipation assembly 12 is reduced while the portion of the cable 20 protruding from the first surface 113 is shielded, thereby reducing costs.

For example, still as shown in FIG. 4, the distance h between the first surface 113 and the end of the heat dissipation assembly 12 away from the second surface 114 may be 1 cm, 10 cm, 30 cm, 50 cm, 70 cm, 90 cm, 100 cm, or the like. During actual design and production, a proper value of the distance h between the first surface 113 and the end of the heat dissipation assembly 12 away from the second surface 114 may be selected based on a type of the cable 20 connected to the chassis 10 and the size of the cable 20 protruding from the first surface 113 after the cable 20 is connected to the chassis 10.

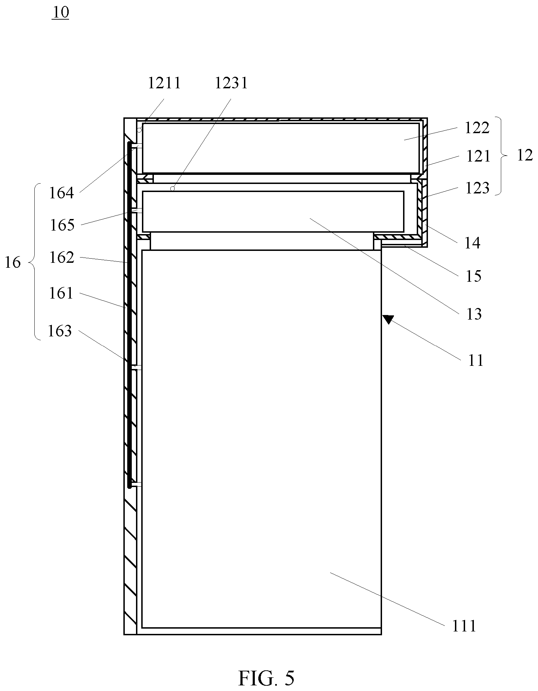

Based on this, in some embodiments of this application, as shown in FIG. 3, a heat dissipation gap 115 is provided between two adjacent boards 111. As shown in FIG. 5, the heat dissipation assembly 12 may include a heat dissipation frame body 121 and at least one fan 122. The heat dissipation frame body 121 has a heat dissipation cavity 1211, and the heat dissipation cavity 1211 is in communication with the heat dissipation gap 115. The fan 122 is disposed in the heat dissipation cavity 1211. When the fan 122 starts to operate, the fan 122 generates an airflow, thereby inducing air flow between the heat dissipation cavity 1211 and the heat dissipation gap 115 that are in communication, thereby allowing hot air in the heat dissipation gap 115 to flow out of the heat dissipation gap 115, reducing the temperature in the heat dissipation gap 115 between the boards 111, and achieving heat dissipation for the boards 111.

In addition, still as shown in FIG. 5, the heat dissipation frame body 121 may protrude from the side of the service structure 11 on which the ports 112 are provided (as shown in FIG. 3). When a foreign object 05 (as shown in FIG. 4) falls during installation or removal of the fan 122, a side of the heat dissipation frame body 121 close to the service structure 11 can shield the connection position between the cable 20 (as shown in FIG. 4) and the port 112. This prevents the cable 20 or the port 112 of the chassis 10 at the connection position from being impacted by the foreign object 05. This further prevents damage to the cable 20 or the chassis 10 caused by the generated foreign object 05 falling and impacting the connection position between the cable 20 and the chassis 10 during the installation and removal of the fan 122. In addition, the heat dissipation frame body 121 protrudes from the service structure 11. That is, a size of an end surface on a side of the heat dissipation frame body 121 facing the service structure 11 may be greater than a size of an end surface on a side of the service structure 11 facing the heat dissipation frame body 121. Compared with a structure in which an end surface of the heat dissipation assembly 12 is flush with an end surface of the service structure 11 in a related technology, the size of the heat dissipation frame body 121 in the chassis 10 provided in this embodiment of this application may be large, and the heat dissipation cavity 1211 of the heat dissipation frame body 121 can accommodate a large quantity of fans 122, so that a heat dissipation effect of the heat dissipation assembly 12 can be improved.

For example, still as shown in FIG. 5, a first air vent (not shown in the figure) communicated with the heat dissipation gap 115 (as shown in FIG. 3) is provided on the side of the heat dissipation frame body 121 facing the service structure 11. The first air vent may be defined by a framework of the heat dissipation frame body 121 facing the service structure 11. A second air vent (not shown in the figure) is provided on a side of the heat dissipation frame body 121 away from the service structure 11, and the second air vent is in communication with the outside atmosphere. When the fan 122 is in operation, air may be supplied to the second air vent, so that an airflow that flows from the first air vent, passes through the heat dissipation cavity 1211, and then flows to the second air vent is generated in the heat dissipation cavity 1211. Because the heat dissipation gap 115 is in communication with the first air vent, an airflow flowing to the first air vent can be generated in the heat dissipation gap 115. Finally, in the chassis 10, an airflow that passes through the heat dissipation gap 115, the first air vent, the heat dissipation cavity 1211, and the second air vent is generated and ultimately flows to the atmosphere through the second air vent, thereby completing heat dissipation of the chassis 10.

On this basis, still as shown in FIG. 5, the heat dissipation assembly 12 may include an air mixing frame body 123. The air mixing frame body 123 is disposed between the service structure 11 and the heat dissipation frame body 121. The air mixing frame body 123 has an air mixing cavity 1231, and the heat dissipation cavity 1211 and the heat dissipation gap 115 (as shown in FIG. 3) are both in communication with the air mixing cavity 1231. Because the heat dissipation cavity 1211 is in communication with the air mixing cavity 1231, when the fan 122 is in operation, air flow is generated between the heat dissipation cavity 1211 and the heat dissipation gap 115 that are in communication. In addition, because the heat dissipation gap 115 is also in communication with the air mixing cavity 1231, after air flow is generated in the air mixing cavity 1231, air flow is generated between the heat dissipation gap 115 and the air mixing cavity 1231 that are in communication. That is, air flow is generated in the heat dissipation gap 115, the air mixing cavity 1231, and the heat dissipation cavity 1211, thereby achieving heat dissipation of the chassis 10. In addition, when the air flows, the airflow converges in the air mixing cavity 1231, thereby generating a uniform airflow in the air mixing cavity 1231. This causes one heat dissipation gap 115 below the air mixing frame body 123 to generate airflows with similar air volumes in different regions on a same horizontal plane, thereby achieving uniform heat dissipation across the different regions of the same heat dissipation gap 115 on the same horizontal plane. Alternatively, when there are a plurality of heat dissipation gaps 115, after the airflow in the air mixing cavity 1231 converges, airflows with similar air volumes can be generated in different heat dissipation gaps 115, thereby achieving uniform heat dissipation across the different heat dissipation gaps 115. In addition, when there are a plurality of fans 122 and one of the fans 122 is faulty, airflows generated by the other fans 122 during operation can converge in the air mixing cavity 1231, to ensure that the heat dissipation assembly 12 can dissipate heat from the heat dissipation gap 115 located below the faulty fan 122.

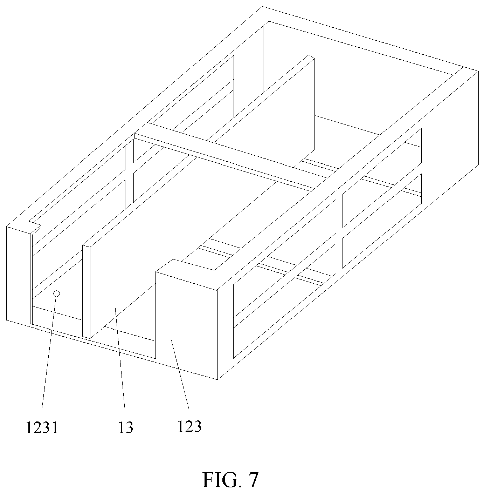

For example, as shown in FIG. 7, the air mixing cavity 1231 is space defined by a framework of the air mixing frame body 123, and a side of the air mixing frame body 123 facing the heat dissipation cavity 1211 (as shown in FIG. 5) and a side of the air mixing frame body 123 facing the service structure 11 (as shown in FIG. 5) are both hollow framework structures. In this way, it can be ensured that air in the heat dissipation gap 115 (as shown in FIG. 3) can flow to the air mixing cavity 1231, and flow to the heat dissipation cavity 1211 through the air mixing cavity 1231. In addition, a side wall of the air mixing frame body 123 may also be a hollow framework structure. In this way, a weight of the air mixing frame body 123 can be reduced, so that installation and removal of the air mixing frame body 123 are facilitated.

Further, still as shown in FIG. 5, the chassis 10 may further include a power board 13 disposed in the air mixing cavity 1231. The boards 111 and the fan 122 are both electrically connected to the power board 13. After the power board 13 is electrically connected to an external power supply, the external power supply transmits electric power to the power board 13. In this case, the power board 13 converts an input power supply voltage into operating voltages of various levels required by the boards 111 and the fan 122, and then distributes the operating voltages to the boards 111 and the fan 122, to ensure energy required by the boards 111 and the fan 122 for operation.

On this basis, as shown in FIG. 7, the power board 13 may be vertically disposed in the air mixing cavity 1231. Because the power board 13 is a plate-shaped structure, and a thickness of the power board 13 is far less than a width of an air mixing structure. That is, the power board 13 occupies very small space in the air mixing cavity 1231. Moreover, because the power board 13 is vertically disposed in the air mixing cavity 1231, in this case, the power board 13 hardly obstructs the vertically directed airflow generated in the air mixing cavity 1231, so that air resistance in the air mixing cavity 1231 can be reduced, and the heat dissipation effect of the heat dissipation assembly 12 (as shown in FIG. 5) can be ensured.

In addition, as shown in FIG. 5, the chassis 10 may further include a cover plate 14 disposed at an end of the air mixing frame body 123 away from the second surface 114. An end of the cover plate 14 facing the service structure 11 is connected to the service structure 11, and an end of the cover plate 14 away from the service structure 11 is connected to the air mixing frame body 123. The cover plate 14 covers an end surface of the air mixing frame body 123 away from the second surface 114. In this case, the cover plate 14 can shield the air mixing frame body 123 and the power board 13, thereby preventing damage to the air mixing frame body 123 or the power board 13 caused by an external foreign object impacting the air mixing frame body 123 or the power board 13, and achieving a purpose of protecting the air mixing frame body 123 and the power board 13 disposed in the air mixing cavity 1231.

Further, still as shown in FIG. 5, the air mixing frame body 123 is detachably connected to the service structure 11. When the air mixing frame body 123 or the power board 13 disposed in the air mixing cavity 1231 needs to be repaired or replaced, the air mixing frame body 123 may be taken out, to facilitate the repair or replacement of the power board 13.

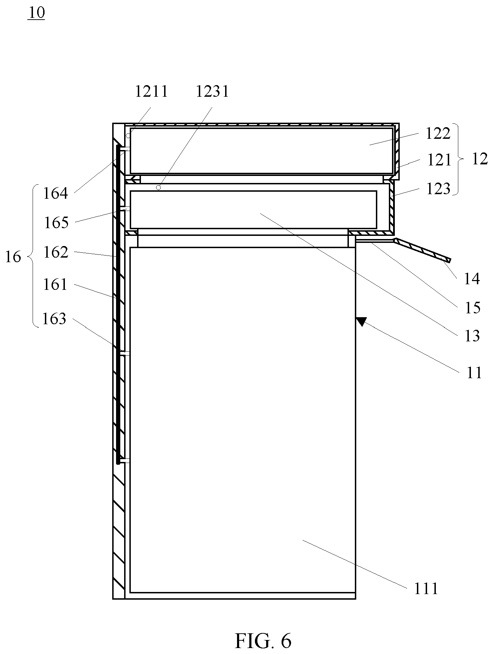

Further, as shown in FIG. 5 and FIG. 6, the chassis 10 may further include a support member 15. The support member 15 is connected to the service structure 11, and the end of the cover plate 14 facing the service structure 11 is rotatably connected to the support member 15. In this way, the support member 15 is connected to the service structure 11, and the end of the cover plate 14 facing the service structure 11 is rotatably connected to the support member 15. When the air mixing frame body 123 is removed, as shown in FIG. 6, the cover plate 14 may be flipped downward, to facilitate taking out the air mixing frame body 123. In addition, after the cover plate 14 is flipped downward, the cover plate 14 may also shield the position of the port 112 (as shown in FIG. 3) of the service structure 11, to prevent a foreign object generated during installation or removal of the air mixing frame body 123 from falling and impacting the connection position between the external cable 20 (as shown in FIG. 4) and the port 112, thereby achieving a purpose of preventing damage to the cable 20 or the chassis 10 caused by the generated foreign object falling and impacting the connection position between the cable 20 and the chassis 10 during the installation and removal of the air mixing frame body 123.

In addition, in some embodiments of this application, still as shown in FIG. 5, the chassis 10 may further include a backplane assembly 16. The service structure 11 and the heat dissipation assembly 12 are both disposed on a same side of the backplane assembly 16. The backplane assembly 16 may include a backplane body 161. The service structure 11 and the heat dissipation assembly 12 are disposed on one side of the backplane body 161, and the backplane body 161 can support the service structure 11 and the heat dissipation assembly 12, thereby ensuring structural stability of the chassis 10.

Still as shown in FIG. 5, the backplane assembly 16 may further include a cable group 162 and a first connector 163 that are disposed on the backplane body 161. One end of the first connector 163 is electrically connected to the cable group 162, and the other end of the first connector 163 is electrically connected to the board 111. In this case, the cable group 162 and the board 111 are both electrically connected to the first connector 163. When electric power is input to the cable group 162, the electric power can be transmitted to the board 111 through the cable group 162 and the first connector 163, to provide energy for the operation of the board 111. In addition, when there are a plurality of boards 111, signal transmission and exchange between different boards 111 can also be performed through the cable group 162.

Still as shown in FIG. 5, the backplane assembly 16 may further include a second connector 164 disposed on the backplane body 161. One end of the second connector 164 is electrically connected to the cable group 162, and the other end of the second connector 164 is electrically connected to the heat dissipation assembly 12. In this case, the cable group 162 and the heat dissipation assembly 12 are both electrically connected to the second connector 164. When electric power is input to the cable group 162, the electric power can be transmitted to the heat dissipation assembly 12 through the cable group 162 and the second connector 164, to provide energy for the operation of the heat dissipation assembly 12.

Still as shown in FIG. 5, the backplane assembly 16 may further include a third connector 165 disposed on the backplane body 161. One end of the third connector 165 is electrically connected to the cable group 162, and the other end of the third connector 165 is electrically connected to the power board 13. The power board 13 is connected to the cable group 162 through the third connector 165. When electric power is input to the power board 13, the electric power is transmitted to the cable group 162 through the third connector 165, and finally delivered to the board 111 and the heat dissipation assembly 12, to provide energy for the operation of the board 111 and the heat dissipation assembly 12.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A chassis, comprising:
a service structure, wherein the service structure comprises a plurality of boards and a plurality of ports, the ports are provided on the boards, and the ports are configured to connect to cables; and
a heat dissipation assembly, stacked on the service structure, wherein the heat dissipation assembly protrudes from a side of the service structure on which the ports are located.

2. The chassis according to claim 1, wherein the service structure has a first surface and a second surface that are opposite to each other, the ports are located on the first surface, and a distance between the first surface and an end of the heat dissipation assembly away from the second surface is h, wherein 0 cm<h≤100 cm.

3. The chassis according to claim 1, wherein a heat dissipation gap is provided between two adjacent boards, and the heat dissipation assembly comprises:
a heat dissipation frame body, wherein the heat dissipation frame body protrudes from the side of the service structure on which the ports are located, the heat dissipation frame body has a heat dissipation cavity, and the heat dissipation cavity is in communication with the heat dissipation gap; and
at least one fan, disposed in the heat dissipation cavity.

4. The chassis according to claim 3, wherein the heat dissipation assembly further comprises:
an air mixing frame body, disposed between the service structure and the heat dissipation frame body, wherein the air mixing frame body has an air mixing cavity, and the heat dissipation cavity and the heat dissipation gap are both in communication with the air mixing cavity.

5. The chassis according to claim 4, wherein the chassis further comprises:
a power board, vertically disposed in the air mixing cavity, and the boards and the fan are both electrically connected to the power board.

6. The chassis according to claim 4, wherein the service structure has a first surface and a second surface that are opposite to each other, the ports are located on the first surface, and the chassis further comprises:
a cover plate, disposed at an end of the air mixing frame body away from the second surface, wherein an end of the cover plate facing the service structure is connected to the service structure, an end of the cover plate away from the service structure is connected to the air mixing frame body, and the cover plate covers an end surface of the air mixing frame body away from the second surface.

7. The chassis according to claim 6, wherein the air mixing frame body is detachably connected to the service structure, and the chassis further comprises:
a support member, wherein the support member is connected to the service structure, and the end of the cover plate facing the service structure is rotatably connected to the support member.

8. The chassis according to any one of claims 1 to 7, wherein the chassis further comprises a backplane assembly, the service structure and the heat dissipation assembly are both disposed on a same side of the backplane assembly, and the backplane assembly comprises:
a backplane body;
a cable group, disposed on the backplane body;
a first connector, disposed on the backplane body, wherein one end of the first connector is electrically connected to the cable group, and the other end of the first connector is electrically connected to the boards; and
a second connector, disposed on the backplane body, wherein one end of the second connector is electrically connected to the cable group, and the other end of the second connector is electrically connected to the heat dissipation assembly.

9. The chassis according to claim 8, wherein the chassis further comprises a power board, the backplane assembly further comprises a third connector, one end of the third connector is electrically connected to the cable group, and the other end of the third connector is electrically connected to the power board.

10. A network device, comprising the chassis according to any one of claims 1 to 9, wherein the network device further comprises a cable, and the cable is connected to a port.

11. A communication system, comprising the network device according to claim 10, wherein the communication system further comprises a first access device, and the first access device is connected to the network device.
